# FASCICULE DE BREVET EUROPEEN

(11) **EP 2 095 505 B1**
(45) Date de publication et mention de la délivrance du brevet: **17.04.2013**
(21) Numéro de dépôt: 08701492.4
(22) Date de dépôt: 15.01.2008
(51) Int. Cl.: H03H 19/00, H03H 17/02, H03H 17/06, H03G 3/30, H03H 15/02, H03H 15/00, G11C 27/02

(54) **IMPLEMENTATION ANALOGUE D'UN FILTRE ECHANTILLONNE A REPONSE IMPULSIONNELLE FINIE UTILISANT UN AMPLIFICATEUR A TRANSCONDUCTANCE A GAIN COMMANDABLE**
ANALOGE IMPLEMENTIERUNG EINES ABTASTFILTERS MIT ENDLICHER IMPULSANTWORT BENUTZEND EINEN TRANSKONDUKTANZVERSTÄRKER MIT STEUERBARER VERSTÄRKUNG
ANALOGUE IMPLEMENTATION OF A SAMPLED FILTER WITH FINITE IMPULSE RESPONSE USING A GAIN-CONTROLLABLE TRANSCONDUCTANCE AMPLIFIER

(30) Priorité: 16.01.2007 FR 0700288
(43) Date de publication de la demande: 02.09.2009
(73) Titulaire: Commissariat à l'Énergie Atomique et aux Énergies Alternatives, 75015 Paris (FR)
(72) Inventeur: WEI, James, 8135 Langnau am Albis (CH); MORCHE, Dominique, F-38240 Meylan (FR)
(74) Mandataire: Guérin, Michel
(86) Numéro de dépôt international: PCT/EP2008/050382
(87) Numéro de publication internationale: WO 2008/090054

(56) Documents cités:
- DE-A1- 3 236 148
- US-A- 5 414 311
- US-A- 5 708 384
- US-A1- 2005 168 371
- US-A1- 2006 164 131
- US-B1- 6 661 283
- US-B2- 7 049 872
- GOODENOUGH F: "LOWER SUPPLY VOLTAGES DRIVE ANALOG AND SENSOR IC DEVELOPMENTS" ELECTRONIC DESIGN, PENTON MEDIA, CLEVELAND, OH, US, vol. 43, no. 9, 1 mai 1995 (1995-05-01), page 80,82,84,86,, XP000507680 ISSN: 0013-4872

## Description

L'invention concerne les filtres échantillonnés à réponse impulsionnelle finie, ou filtres FIR.

Un tel filtre est un circuit qui échantillonne un signal analogique d'une manière particulière : N échantillons successifs sont prélevés à une fréquence d'échantillonnage Fe, et on fait l'addition des N échantillons, pondérés par des coefficients individuels qui sont choisis en fonction de la fonction de transfert de filtrage à obtenir. La sortie du circuit est constituée par des échantillons fournis à une fréquence Fe/N, c'est-à-dire la fréquence d'échantillonnage divisée par le nombre d'échantillons sommés ; cette succession représente le signal analogique échantillonné à la fréquence dite "fréquence de décimation" Fe/N et affecté d'une fonction de filtrage qui est déterminée par le choix des N coefficients de pondération. Le nombre N peut être d'une dizaine ou plusieurs dizaines, voire même plusieurs centaines.

Un filtrage de ce type peut être utilisé par exemple pour traiter un signal radiofréquence en faisant simultanément un changement de fréquence vers une fréquence intermédiaire ou une bande de base, et un filtrage de réjection de bruit ou de bandes de télécommunications voisines.

Le filtrage échantillonné comprend au moins un échantillonneur-bloqueur, simple ou différentiel selon que le signal d'entrée est simple ou différentiel. L'échantillonneur-bloqueur peut recevoir le signal soit sous forme de tension, soit sous forme de courant. Pour travailler en haute fréquence d'échantillonnage, il est souvent préférable d'utiliser un courant. Ceci permet de réduire l'influence du bruit d'horloge ; le bruit d'horloge (parfois aussi appelé "jitter" ou gigue d'horloge) perturbe en effet plus l'échantillonnage en tension que l'échantillonnage en courant.

Comme le signal d'entrée à convertir se présente généralement sous forme d'une tension (ou plus exactement de variations de tension à haute fréquence), il faut placer en amont de la ou les capacités d'échantillonnage un amplificateur à transconductance de grande qualité qui va convertir très précisément les variations de tension en variations de courant.

Dans l'art antérieur, on a déjà proposé des filtres FIR utilisant un amplificateur à transconductance dont la sortie est appliquée à des capacités d'échantillonnage. La structure la plus classique comporte N capacités d'échantillonnage à la sortie de l'amplificateur à transconductance. La conversion se fait sur N cycles et des commutateurs aiguillent le courant à échantillonner successivement vers les différentes capacités. Puis, à la fin des N cycles, les charges stockées correspondant aux N échantillons sont sommées, par le moyen d'un amplificateur opérationnel, sur une capacité commune. La pondération individuelle des échantillons se fait en donnant des valeurs différentes aux N capacités. Si le nombre N est grand, il faut beaucoup de condensateurs, et si les coefficients du filtre FIR doivent être programmables pour modifier la fonction de filtrage, chaque condensateur doit avoir une valeur programmable. La programmation d'un coefficient se fait alors en sélectionnant un capacité parmi plusieurs possibles, et on comprend que cela multiplie encore le nombre de capacités et le nombre de commutateurs d'aiguillage vers chacune des capacités possibles. Il y a des problèmes d'encombrement, des problèmes d'appariement des capacités, et des problèmes de parasites introduits par les très nombreux commutateurs nécessaires dans le système.

D'autres structures de filtres ont été proposées : on en trouvera des exemples dans les documents suivants :

S. Karvonen et al., « A 50-MHz CMOS Quadrature Charge Sampling Circuit with 66 dB SFDR, » Proceedings of the 2004 IEEE International Symposium on Circuits and Systems, Vancouver, pp 217-220, May 2004. Les coefficients du filtre ne sont pas programmables.

US Patent 7,023,245, "Versatile charge sampling circuits", April 4, 2006. Le signal échantillonné est une tension et non pas un courant et cette tension est appliquée à une capacité à travers une résistance de valeur programmable. Le signal d'entrée est atténué de manière variable ; l'atténuation est fonction de la constante de temps du montage, elle-même variable puisque la résistance varie. La bande passante est forcément limitée par cette constante de temps. Enfin, on ne peut pas réaliser n'importe quel coefficient avec ce montage, et en particulier pas des coefficients supérieurs à 1.

US5414311, Fig. 10. Plusieurs amplificateurs à transconductance ont un gain constant et définissent une fonction de filtrage désirée en interopérant avec un réseau d'interrupteurs.

Le but de l'invention est de proposer une meilleure architecture pour réaliser un filtre échantillonné fonctionnant par intégration de charges.

Selon l'invention, on propose un filtre échantillonné à réponse impulsionnelle finie selon la revendication 1.

Il peut y avoir deux capacités d'échantillonnage reliées à la sortie, travaillant alternativement sur des séries de N échantillons successifs, l'une des capacités fonctionnant en échantillonnage pendant que l'autre fonctionne en maintien et lecture de la charge accumulée, les rôles étant inversés lors de la série suivante.

L'amplificateur peut fonctionner en différentiel. L'échantillonnage se fait simultanément sur les deux sorties ; ensuite, pour obtenir le signal d'échantillonnage différentiel, on prend la différence entre les deux échantillons provenant des deux sorties différentielles. Le coefficient de pondération est le même pour les deux échantillons.

Et de plus, si le filtre doit effectuer un échantillonnage I,Q en quadrature de phase fournissant sur sa ou ses sorties des échantillons I est des échantillons Q en quadrature de phase, alors on double encore le nombre de capacités d'échantillonnage : il y a autant de capacités d'échantillonnage destinées à accumuler N échantillons I que de capacités d'échantillonnage destinées à accumuler N échantillons Q.

Par conséquent, si le filtre échantillonné travaille en alternance (phase de maintien alternée avec une phase de lecture pour une capacité et inversion de ces phases pour l'autre), si de plus il fonctionne en différentiel, et si enfin il fournit des échantillons en quadrature de phase, on comprend qu'il faut en principe huit capacités d'échantillonnage différentes.

Pour régler le gain de l'amplificateur à transconductance, on peut utiliser notamment
- un réseau de résistances commandable par des signaux logiques pour ajuster le gain de l'amplificateur à transconductance ; le réseau forme par exemple un pont diviseur à rapport commandable ;
- ou encore un transistor MOS pour constituer une résistance variable commandée par une tension de grille, avec un convertisseur numérique-analogique pour recevoir des signaux logiques de commande de gain et les convertir en une tension analogique de grille du transistor.

Ce réseau de résistances ou ce transistor MOS peuvent être placés à l'entrée en tension de l'amplificateur à transconductance, pour recevoir un signal en tension et atténuer cette tension dans un rapport réglable avant de convertir la tension atténuée en courant avec un gain de transconductance défini par le coeur de l'amplificateur. Ils peuvent aussi être placés à l'intérieur de l'amplificateur à transconductance lui-même si ce dernier possède une structure comportant un élément résistif pour transformer des variations de tension en variations de courant avec un gain déterminé par la valeur de la résistance de l'élément ; c'est alors cet élément résistif qui est constitué par un réseau de résistances sélectionnable par des signaux logiques ou par un transistor MOS commandé par une tension de grille variable. '

D'autres caractéristiques et avantages de l'invention apparaîtront à la lecture de la description détaillée qui suit et qui est faite en référence aux dessins annexés dans lesquels :
- la figure 1 représente un filtre FIR de l'art antérieur ;
- la figure 2 représente le principe général de l'invention ;
- la figure 3 est un chronogramme de fonctionnement du circuit de la figure 1 ;
- la figure 4 représente un exemple d'amplificateur à transconductance utilisable dans l'invention ;
- la figure 5 représente un autre exemple de réalisation de la commande de gain dans l'amplificateur à transconductance ;
- la figure 6 représente un filtre échantillonné I,Q selon l'invention, utilisant un amplificateur à transconductance à gain variable ;
- la figure 7 représente le chronogramme correspondant à l'actionnement des commutateurs de la figure 6.

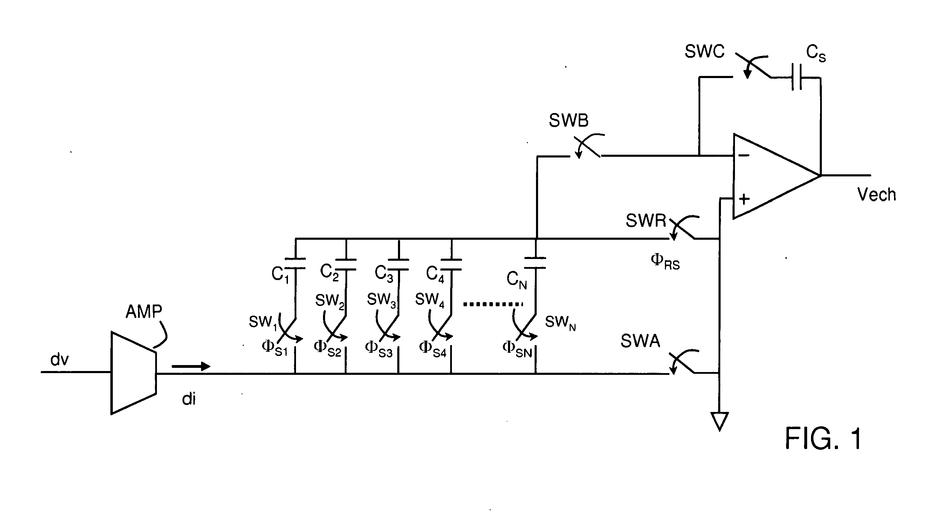

Le schéma le plus traditionnel d'un filtre échantillonné à réponse impulsionnelle finie fonctionnant en échantillonnage de charges et non de tensions est représenté sur la figure 1.

Un amplificateur à transconductance AMP convertit le signal d'entrée de tension dv (seuls les petits signaux sont considérés ici, et non les polarisations ou tensions de mode commun) en un courant di. Le courant est appliqué successivement par des interrupteurs SW₁, SW₂, SW₃, ... SW_{N}, sous la commande d'un séquenceur d'échantillonnage non représenté, à N capacités C₁, C₂, C₃... C_{N}. L'autre borne des capacités est mise pendant ce temps à la masse par un commutateur SWR fermé. A chaque période d'échantillonnage une capacité déterminée intègre le courant di pendant un temps qui est le même pour toutes les capacités (une demi-période d'horloge à fréquence Fe par exemple) ; à la période suivante c'est la capacité suivante qui intègre les charges. Les phases d'échantillonnage successives sont désignées par Φ_{S1}, Φ_{S2}, Φ_{S3}, ...Φ_{SN}. La charge intégrée dans les capacités prend des valeurs qui représentent les échantillons successifs de la tension d'entrée dv. Après un cycle de N phases d'échantillonnage Φ_{S1}, Φ_{S2}, Φ_{S3}, ... Φ_{SN}, les capacités sont chargées chacune par un échantillon respectif de charges. Le commutateur SWR est alors ouvert et tous les commutateurs SW₁, SW₂, SW₃, ... SW_{N} sont refermés. Sont fermés également trois autres commutateurs qui étaient ouverts pendant les N phases d'échantillonnage : un commutateur SWA qui relie tous les commutateurs SW₁, SW₂, SW₃, ... SW_{N} à la masse, un commutateur SWB qui relie les capacités à l'entrée négative d'un amplificateur opérationnel AOP, et un commutateur SWC qui connecte une capacité de sommation Cs entre cette entrée négative et la sortie de l'amplificateur opérationnel. Les charges stockées dans les N capacités C₁, C₂, C₃... C_{N} sont transférées sur la capacité Cₛ où elles s'additionnent. La tension de sortie de l'amplificateur représente alors une sommation de N échantillons, et la pondération des échantillons est déterminée par les valeurs individuelles des N capacités, un échantillon de charges étant le produit du courant di par la valeur de la capacité associée à cet échantillon. L'échantillon fourni à la sortie est établi avec une fréquence de décimation Fe/N. Toutes les capacités sont déchargées vers la fin de la phase de fermeture des commutateurs SWA, SWB et SWC par une fermeture à nouveau du commutateur de remise à zéro SWR (phase de remise à zéro Φ_{RS} avant que les commutateurs SWA, SWB et SWC, actionnés à la fréquence Fe/N ne se rouvrent pour un nouveau cycle de N phases d'échantillonnage.

Comme on l'a dit, ce type d'échantillonneur utilise de nombreuses capacités, surtout si chaque capacité doit avoir une valeur programmable comme c'est le cas pour un filtre FIR à coefficients de pondération programmable. Le nombre de commutateurs est également très grand. Cela pose des problèmes de routage de connexions, d'appariement des capacités, et des parasites dus aux très nombreuses commutations.

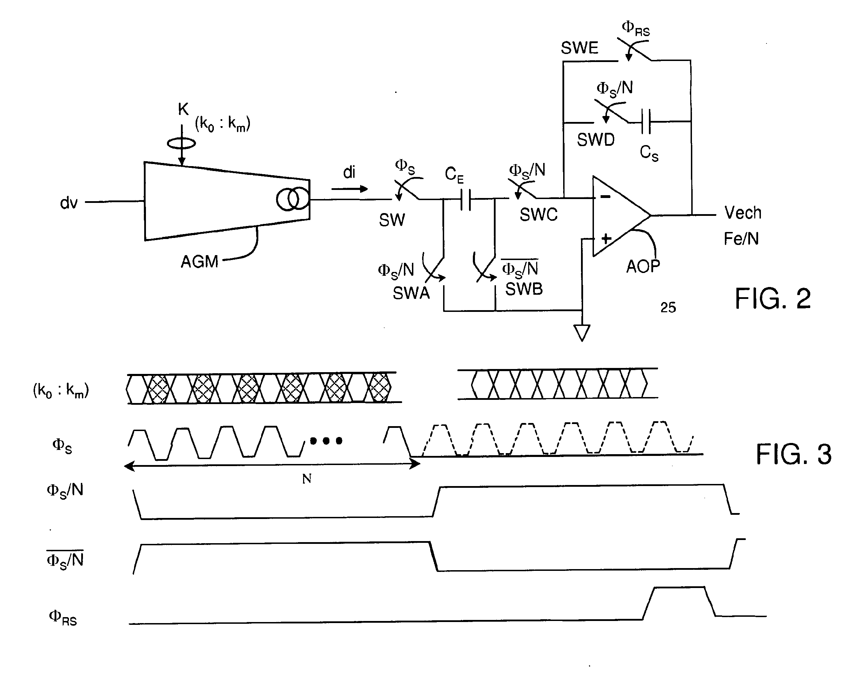

La figure 2 représente le principe du filtre échantillonné selon l'invention, appliqué à une intégration active de charges, c'est-à-dire en utilisant un amplificateur opérationnel. L'amplificateur opérationnel n'est cependant pas obligatoire.

Il n'y a plus N capacités d'échantillonnage mais une seule, désignée par CE. Il y a toujours un amplificateur opérationnel AOP avec une capacité de rebouclage Cs. Des commutateurs sont prévus, l'un d'eux (SW) étant actionné à la fréquence d'échantillonnage Fe et les autres (SWA, SWB, SWC, SWD) étant actionnés à la fréquence de décimation Fe/N, où N est ici encore le nombre d'échantillons qui seront sommés avec pondération pour fournir périodiquement, au bout de chaque série de N cycles d'intégration, un échantillon de tension Vech en sortie de l'amplificateur opérationnel AOP.

Le filtre comprend un amplificateur à transconductance à gain commandé AGM. Le gain peut être commandé par une entrée de commande de gain désignée par K. Le gain peut prendre une valeur quelconque k parmi m valeurs possibles k₀ à kₘ. La commande est une commande numérique et on verra plus loin comment on peut réaliser cette commande. Le gain considéré ici est un gain de transconductance, à savoir le rapport di/dv entre le courant en petits signaux en sortie de l'amplificateur et la tension en petits signaux à l'entrée.

La sortie de l'amplificateur à transconductance est appliquée, à travers le commutateur SW à une première borne de la capacité d'échantillonnage C_{E}. Cette borne peut être mise à la masse Vₛₛ par le commutateur SWA, actionné à la fréquence Fe/N. La phase de fermeture de SWA est désigné par Φ_{S}/N. L'autre borne de la capacité C_{E} peut être mise à la masse par le commutateur SWB actionné en opposition de phase avec SWA. Par ailleurs elle peut être reliée à l'entrée négative de l'amplificateur opérationnel AOP par le commutateur SWC actionné en phase avec SWA. L'entrée positive de l'amplificateur AOP est à la masse. La capacité de sortie ou capacité de rebouclage C_{S} a une borne connectée à la sortie de l'amplificateur AOP pour établir la tension d'échantillonnage de sortie Vech à la fréquence de décimation Fe/N. L'autre borne de la capacité peut être reliée à l'entrée négative de l'amplificateur AOP par le commutateur SWD actionné en phase avec SWA et SWC. Enfin, un commutateur SWE de remise à zéro, actionné pendant une phase Φ_{RS}, peu avant la fin de la phase Φ_{S}/N de fermeture des commutateurs SWA et SWC, permet de remettre à zéro la charge de la capacité Cs et par conséquence la charge de la capacité C_{E}.

Le chronogramme de fonctionnement de ce circuit est rappelé sur la figure 3.

Le circuit fonctionne de la manière suivante : pour une courbe de réponse du filtre donnée, il faut définir les N coefficients de pondération associés aux N échantillons d'un cycle. Il n'y a pas forcément N valeurs toutes différentes ; il peut y avoir m valeurs possibles et la réponse du filtre est définie par la séquence de N valeurs où chaque valeur est prise parmi m possibles. A chaque valeur possible correspond un gain k pris parmi les valeurs de gain possibles k₀ à kₘ. A l'intérieur de chaque cycle de N échantillons, on donne à l'amplificateur à transconductance une succession rapide (à la fréquence Fe) de gains k différents pris parmi les m valeurs.

L'amplificateur à transconductance AGM produit donc une succession d'échantillons de courant di qui représentent l'échantillon de tension d'entrée dv pondéré par un gain k qui sera différent d'un échantillon à l'autre : di=k.dv. Chaque échantillon de courant est intégré dans la capacité C_{E} pendant une durée fixe de fermeture du commutateur SW ; chaque échantillon de charges est donc pondéré, non pas par la valeur de la capacité mais par la valeur du gain de transconductance de l'amplificateur AGM.

Dans un cycle de N phases d'horloge à fréquence Fe, on applique successivement par le commutateur SW N échantillons de charges pondérés à la capacité C_{E}, sans remettre celle-ci à zéro à chaque commutation. Les commutateurs SWA, SWC, SWD sont ouverts. Le commutateur SWB est fermé. La valeur de pondération k est modifiée au rythme de l'horloge Fe, et ceci pendant que le commutateur SW est ouvert.

Au bout de N phases d'échantillonnage, la capacité C_{E} a recueilli la somme de N échantillons de charge pondérés par les gains k.

On passe alors à une phase de lecture de la charge accumulée dans la capacité C_{E} : on ouvre le commutateur SWB et on ferme les commutateurs SWA, SWC, SWD. Le commutateur SWE est ouvert.

Le commutateur SW est de préférence maintenu ouvert pendant la phase de lecture. Cependant, on peut aussi prévoir un autre commutateur, non représenté, entre le commutateur SW et la capacité CE, pour déconnecter complètement la capacité C_{E} de l'amplificateur à transconductance pendant toute la phase de lecture même si le commutateur SW continue à s'ouvrir et se fermer à la fréquence Fe. Ce commutateur supplémentaire est de toutes façons nécessaire dans les systèmes à échantillonnage alterné où on fait une prise d'échantillon dans une capacité CE pendant la lecture d'une capacité C'_{E} et réciproquement. Il est commandé par le complément du signal Φ_{S/N} et il aiguille les échantillons de courant vers l'autre capacité C'_{E} pendant la lecture de C_{E} et réciproquement.

La capacité de rebouclage Cs recueille la somme pondérée de charges accumulée dans la capacité C_{E}. La tension de sortie Vech représente un échantillon de sortie du filtre échantillonné. Cet échantillon se renouvelle à la fréquence de décimation Fe/N.

L'échantillon Vech peut être exploité en aval pendant la première partie de la phase Φₛ/N où les commutateurs SWA, SWC, SWD sont fermés et SWE est ouvert. Avant la fin de cette phase, le commutateur SWE est fermé (phase Φ_{RS}) pour remise à zéro des capacités Cs et C_{E}.

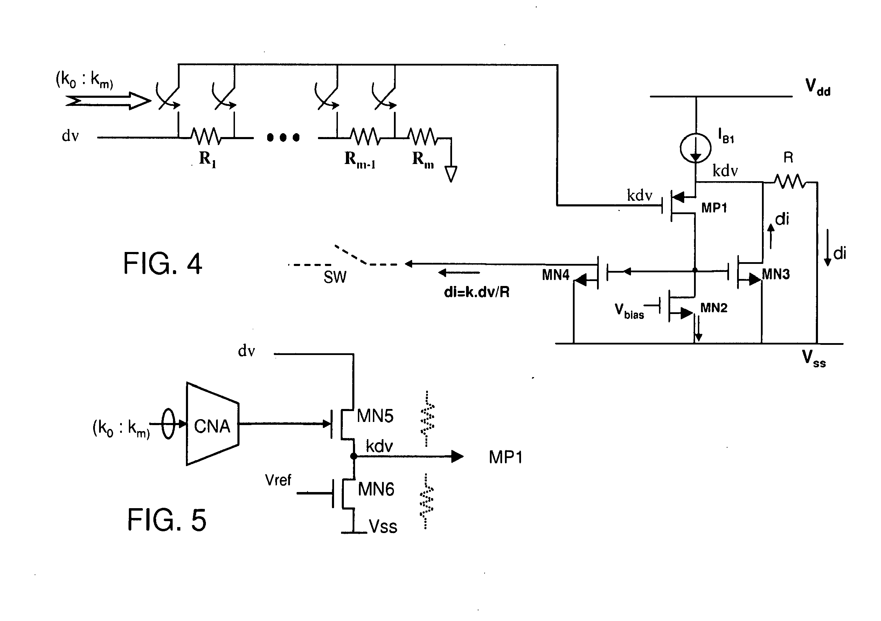

La figure 4 représente un exemple d'amplificateur à transconductance à gain réglable pouvant être utilisé pour faire le filtre à réponse impulsionnelle finie selon l'invention. La tension d'entrée en petits signaux dv est appliquée à un pont diviseur à m résistances R₁ à Rₘ. La sortie du pont diviseur fournit une tension kdv qui varie selon la position du noeud de sortie du pont diviseur. Un commutateur associé à chaque nceud permet de sélectionner une valeur de rapport de division k, sous la commande de signaux numériques. Les signaux numériques sont appliqués à la fréquence d'échantillonnage pour qu'à chaque échantillon à fréquence Fe corresponde une valeur de rapport de division k. Les valeurs des résistances sont toutes identiques ou bien elles sont différentes les unes des autres : cela dépend des valeurs des m coefficients de pondération désirés.

On pourrait aussi avoir un nombre de résistances inférieur au nombre de coefficients à réaliser, si on a la possibilité de fermer plusieurs commutateurs à la fois pour établir certains rapports de division.

La tension de sortie du pont diviseur, kdv, est appliquée à la grille d'un transistor PMOS MP1 monté en suiveur, qui reporte cette tension kdv sur sa source. Le transistor est alimenté par une source de courant I_{B1} et il est en série avec un transistor NMOS MN2 monté en source de courant constant, dont la grille est polarisée par une tension constante V_{bias}. Une résistance de valeur R est reliée entre la source de MP1 et la masse et est parcourue par un courant di=k.dv/R. Un transistor MN3 est disposé entre la source de MP1 et la masse ; sa grille est commandée par les drains réunis de MP1 et MN2.

Schématiquement, on peut dire pour simplifier que le courant k.dv/R dans la résistance R ne peut pas provenir de la source de courant I_{B1} ni du courant dans le transistor MP1 car ces courants sont constants et ne varient pas avec dv. Par conséquent il ne peut provenir que du transistor MN3. Le transistor, MN3 est donc parcouru par un courant di = kdv/R.

Un transistor de sortie MN4, identique au transistor MN3, est monté en miroir de courant et fournit sur son drain un courant di=k.dv/R ; c'est ce courant pondéré par le rapport de division k qui est appliqué à l'interrupteur SW de la figure 2.

Plutôt qu'un pont diviseur à multiples résistances R₁ à Rₘ, on pourrait utiliser une résistance variable commandée par un signal analogique. Typiquement cette résistance variable serait alors constituée par un transistor MOS MN5 dont la grille est commandée par une tension analogique variable, et cette tension analogique peut être fournie par un convertisseur numérique analogique (CNA) qui reçoit sous forme numérique, à la fréquence d'échantillonnage Fe, une valeur de coefficient de pondération à établir. La figure 5 représente un tel montage qui peut être substitué au pont diviseur de la figure 4 : le pont ne comporte plus que le transistor MN5 et une résistance, et la résistance peut elle-même être réalisée sous forme d'un transistor MOS MN6 dont la grille est à un potentiel fixe.

Qu'il y ait un pont à deux résistances (figure 5) ou un pont à m résistances (figure 4), on comprend que même si le nombre m de valeurs possibles de coefficients est limité, le nombre N d'échantillons n'est pas limité, et on peut élaborer des fonctions de filtrage sophistiquées.

Enfin, plutôt que de réaliser un pont diviseur à l'entrée de l'amplificateur à transconductance, en amont du transistor MP1, on peut envisager d'utiliser une résistance variable ou un réseau de résistances commandable à la place de la résistance R qui détermine le rapport de conversion tension/courant. En effet, si on applique directement la tension dv à la grille du transistor MP1, et si on a une résistance R/k au lieu de R, on comprend que le courant produit est encore di=kdv/R

L'amplificateur à transconductance représenté sur la figure 4 n'est pas différentiel. Un amplificateur différentiel pourrait être réalisé avec deux amplificateurs symétriques, la résistance R qui était reliée à la masse étant alors remplacée par une résistance 2R reliée entre les sources des transistors MP1 des deux amplificateurs.

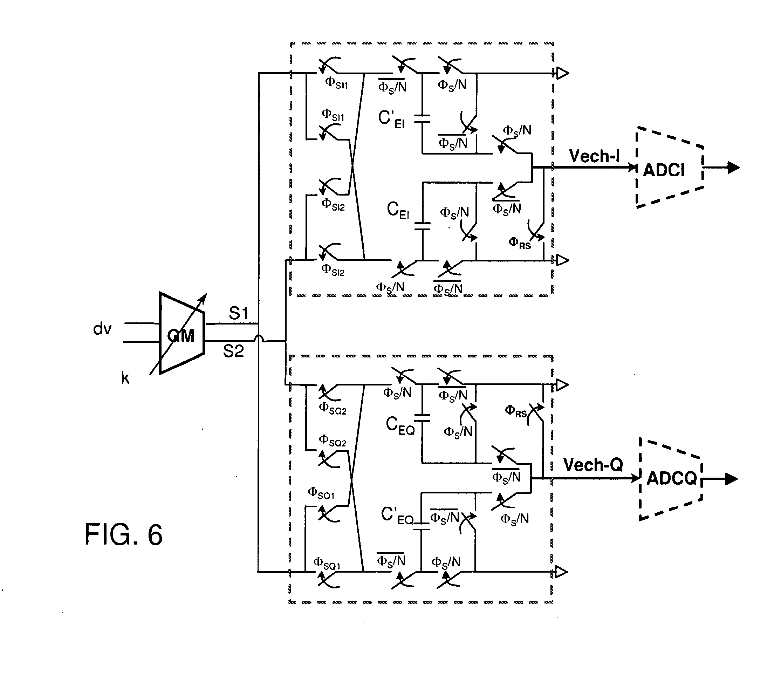

La figure 6 représente un filtre à réponse impulsionnelle finie selon l'invention, appliqué au cas où le signal d'entrée est différentiel et sert à établir des échantillons I est des échantillons Q en quadrature de phase, le filtre utilisant pour chaque échantillon deux capacités de filtrage fonctionnant en alternance échantillonnage/lecture. La sortie de ce filtre n'est pas différentielle ; cependant l'amplificateur à transconductance à gain variable AGM est différentiel et comporte deux sorties S1 et S2. Si la sortie du filtre devait être différentielle, il faudrait doubler le nombre de capacités et prévoir des commutateurs associés.

Il y a deux capacités d'échantillonnage C_{EI} et C'_{EI} travaillant en alternance pour accumuler les échantillons I, et deux capacités d'échantillonnage C_{EQ} et C'_{EQ} travaillant en alternance pour accumuler les échantillons Q. En outre, chaque capacité reçoit successivement un échantillon de charges de la sortie différentielle S1 suivi d'un échantillons de charges de la sortie différentielle S2, avec des signes opposés de manière que les échantillons s'additionnent et ne se soustraient pas dans la capacité. On prévoit donc que les sorties S1 et S2 fournissent les charges avec le même signe.

Les capacités C_{EI} et C_{EQ} reçoivent des échantillons pendant les phases Φₛ/N de la fréquence de décimation Fe/N. Elles sont lues pendant les phases complémentaires de cette fréquence. La remise à zéro par la phase Φ_{RS} a lieu à la fin de la phase complémentaire. Les capacités désignées par l'indice prime travaillent en alternance avec les premières.

Sur la figure 6, les commutateurs du filtre sont désignés par les phases qui les contrôlent ; ces commutateurs sont de trois sortes :
- ceux qui sont actionnés par des impulsions à la fréquence d'échantillonnage Fe et qui jouent le rôle du commutateur SW de la figure 2 ; l'indice 1 dans le nom de la phase signifie qu'ils appliquent à une capacité la sortie S1 de l'amplificateur à transconductance différentiel ; l'indice I ou Q signifie qu'ils concernent le stockage d'un échantillon I ou Q ;
- ceux qui sont actionnés par la fréquence de décimation Fe/N et qui jouent le rôle des commutateurs SWA ou SWC de la figure 2 pendant une phase d'échantillonnage et SWB pendant la phase de lecture, aussi bien pour les capacités C_{E} que pour les capacités C'_{E}, les phases étant inversées pour ces dernières ;
- et ceux qui sont actionnés par l'impulsion de remise à zéro Φ_{RS} et qui jouent le rôle du commutateur SWE de la figure 2.

Pendant une phase d'échantillonnage relative aux capacités C_{EI} et C_{EQ} quatre commutations se produisent successivement :
- application d'un échantillon de charges de la sortie S vers la capacité C_{EI} ;
- en quadrature de phase, c'est-à-dire avec un décalage temporel d'un quart de période 1/Fe de l'horloge d'échantillonnage, application d'un échantillon de la sortie S1 à la capacité C_{EQ} ;
- au coup d'horloge suivant, application d'un échantillon de la sortie S2 à la capacité C_{EI} ;
- et enfin, avec un nouveau décalage en quadrature, application d'un échantillon de la sortie S2 à la capacité C_{EQ}.

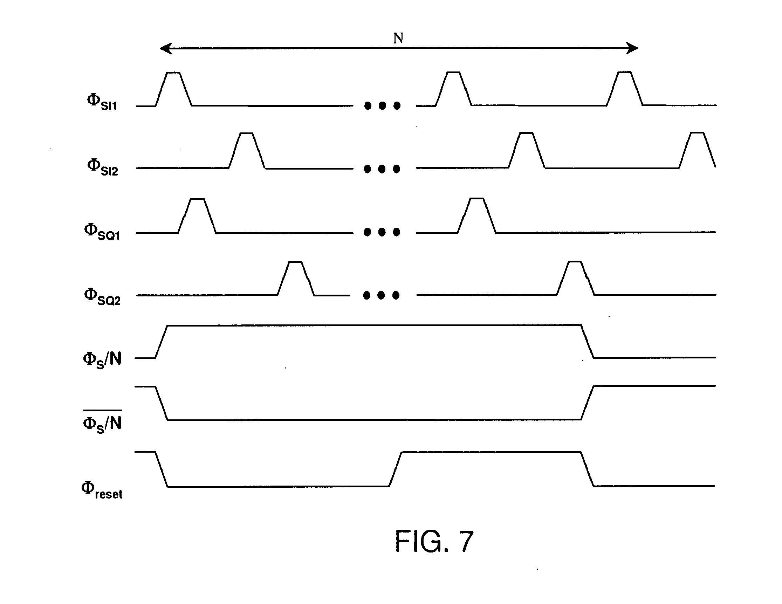

Le chronogramme des signaux correspondants est représenté sur la figure 7.

La sortie du bloc d'échantillonnage de la voie I fournit un niveau analogique échantillonné Vech-I ; la sortie du bloc d'échantillonnage de la voie Q fournit un niveau analogique échantillonné Vech-Q.

On n'a pas représenté sur la figure 6 un échantillonnage utilisant un amplificateur opérationnel AOP. Un tel amplificateur est de toutes façons facultatif. On a représenté en aval du filtre FIR un convertisseur analogique-numérique ADCI et ADCQ sur les voies respectives I et Q, pour une application où on souhaite des sorties numériques.

Le filtre échantillonné selon l'invention peut être utilisé par exemple pour réaliser une fonction de filtrage passe-bas ou passe-bande en même temps qu'une fonction de changement de fréquence. On peut filtrer les bruits et les signaux de brouillage dans des applications de récepteurs radio. L'adaptation de la bande passante et de la réponse fréquentielle sont possibles en jouant sur l'aspect programmable des coefficients de pondération des échantillons ainsi que sur le nombre N des échantillons.

Avec un schéma tel que celui de la figure 6, les commutateurs reliés aux sorties différentielles S1 et S2 permettent d'inverser la polarité du signal de sortie. Il est donc possible de générer un coefficient de pondération positif ou un coefficient de pondération négatif, en fonction de la position des commutateurs.

## Revendications

1. Filtre échantillonné à réponse impulsionnelle finie destiné à recevoir un signal analogique et à produire des échantillons de signal filtré, chaque échantillon de signal filtré représentant une sommation pondérée de N échantillons successifs du signal analogique avec N coefficients de pondération individuels choisis en fonction de la fonction de filtrage à réaliser, **caractérisé en ce qu'**il comporte un amplificateur à transconductance (AGM) à gain de transconductance commandable recevant le signal analogique et fournissant un courant de sortie représentant la valeur de ce signal multipliée par un gain de transconductance (k) de l'amplificateur, au moins une capacité d'échantillonnage (CE) reliée par un commutateur (SW) à la sortie de l'amplificateur à transconductance de manière à recevoir N échantillons successifs de charges apportées par le courant de sortie (di) de l'amplificateur et à accumuler périodiquement les charges produites par ces N échantillons successifs, et des moyens de commande du gain de transconductance de l'amplificateur aptes à donner un gain individuel désiré à l'amplificateur pour chacun des N échantillons, la succession des N gains définissant la fonction de filtrage désirée.

2. Filtre échantillonné selon la revendication 1, **caractérisé en ce qu'**il comporte au moins deux capacités d'échantillonnage (C_{EI}, C'_{EI}) reliées à la sortie de l'amplificateur, travaillant alternativement sur des séries de N échantillons successifs, l'une des capacités fonctionnant en échantillonnage pendant que l'autre fonctionne en maintien et lecture de la charge accumulée.

3. Filtre échantillonné selon l'une des revendications 1 et 2, **caractérisé en ce que** l'amplificateur à transconductance comporte deux sorties différentielles (S1, S2) appliquées toutes deux à au moins une même capacité d'échantillonnage (C_{EI}).

4. Filtre échantillonné selon l'une des revendications 1 à 3, pour un échantillonnage en quadrature de phase fournissant sur sa ou ses sorties des échantillons I est des échantillons Q en quadrature de phase les uns avec les autres, **caractérisé en ce qu'**il comporte autant de capacités d'échantillonnage (C_{EI}, C'_{EI}) destinée à accumuler N échantillons I que de capacités d'échantillonnage (C_{EQ}, C'_{EQ}) destinées à accumuler N échantillons Q.

5. Filtre échantillonné selon l'une des revendications 1 à 4, **caractérisé en ce qu'**il comporte un réseau de résistances (R₁, ..Rₘ) commandable par des signaux logiques pour ajuster le gain de l'amplificateur à transconductance.

6. Filtre échantillonné selon l'une des revendications 1 à 5, **caractérisé en ce qu'**il comporte un transistor MOS (MN5) pour constituer une résistance variable commandée par une tension de grille, et un convertisseur numérique-analogique (CNA) pour recevoir des signaux logiques de commande de gain et les convertir en une tension de grille du transistor.

7. Filtre échantillonné selon l'une des revendications 5 et 6, **caractérisé en ce que** le moyen pour régler le gain est placé à l'entrée en tension de l'amplificateur à transconductance, pour recevoir un signal en tension et atténuer cette tension dans un rapport réglable avant de convertir la tension atténuée en courant.

8. Filtre échantillonné selon l'une des revendications 5 et 6, **caractérisé en ce que** l'amplificateur à transconductance comporte un élément résistif (R) pour transformer des variations de tension (dv) en variations de courant (di) avec un gain déterminé par la valeur de la résistance, et en que cet élément résistif est un ensemble de résistances sélectionnables par des signaux logiques pour constituer une résistance ayant une valeur choisie parmi plusieurs possibles.

9. Filtre échantillonné selon l'une des revendications 5 et 6, **caractérisé en ce que** l'amplificateur à transconductance comporte un élément résistif (R) pour transformer des variations de tension (dv) en variations de courant (di) avec un gain déterminé par la valeur de la résistance, et en que cet élément résistif est un transistor MOS commandé par une tension de grille variable.

## Claims

1. A sampled filter with finite impulse response for receiving an analog signal and for producing filtered signal samples, each filtered signal sample representing a weighted sum of N successive samples of the analog signal with individual weighting coefficients chosen according to the filtering function to build, **characterized in that** it comprises a transconductance amplifier with controllable gain (AGM) receiving the analog signal and providing an output current representing the value of this signal multiplied by a transconductance gain (k) of the amplifier, at least one sampling capacitor (C_{E}) connected through a switch (SW) to the output of the amplifier so as to receive N successive samples of charges brought by the output current (di) from the amplifier and to periodically accumulate the charges produced by those N successive samples, and means for controlling the transconductance gain of the amplifier capable of giving to the amplifier a desired individual gain for each of the N samples, the succession of the N gains defining the desired filtering function.

2. The sampled filter as claimed in claim 1, **characterized in that** it comprises at least two sampling capacitors (C_{EI}, C'_{EI}) linked to the output of the amplifier, working alternately on series of N successive samples, one of the capacitors operating by sampling while the other operates by holding and reading the accumulated charge.

3. The sampled filter as claimed in one of claims 1 and 2, **characterized in that** the transconductance amplifier comprises two differential outputs (S1, S2) both applied to at least one same sampling capacitor (C_{EI}).

4. The sampled filter as claimed in one of claims 1 to 3, for a phase quadrature sampling providing, on its output or outputs, samples I and samples Q in phase quadrature with one another, **characterized in that** it comprises as many sampling capacitors (C_{EI}, C'_{EI}) intended to accumulate N samples I as sampling capacitors (C_{EQ}, C'_{EQ}) intended to accumulate N samples Q.

5. The sampled filter as claimed in one of claims 1 to 4, **characterized in that** it comprises a network of resistors (R₁,..Rₘ) which can be controlled by logic signals to adjust the gain of the transconductance amplifier.

6. The sampled filter as claimed in one of claims 1 to 5, **characterized in that** it comprises a MOS transistor (MN5) to constitute a variable resistor controlled by a gate voltage, and a digital-analog converter (DAC) for receiving gain control logic signals and converting them into a gate voltage of the transistor.

7. The sampled filter as claimed in one of claims 5 and 6, **characterized in that** the means for adjusting the gain is placed at the voltage input of the transconductance amplifier, so as to receive a voltage signal and attenuate this voltage in an adjustable ratio before converting the attenuated voltage into current.

8. The sampled filter as claimed in one of claims 5 and 6, **characterized in that** the transconductance amplifier comprises a resistive element (R) for transforming voltage variations (dv) into current variations (di) with a gain determined by the value of the resistor, and **in that** this resistive element is a set of resistors selectable by logic signals so as to constitute a resistor having a value chosen from among several possible values.

9. The sampled filter as claimed in one of claims 5 and 6, **characterized in that** the transconductance amplifier comprises a resistive element (R) for transforming voltage variations (dv) into current variations (di) with a gain determined by the value of the resistor, and **in that** this resistive element is a MOS transistor controlled by a variable gate voltage.

## Patentansprüche

1. Abtastfilter mit endlicher Impulsantwort zum Empfangen eines Analogsignals und zum Erzeugen von gefilterten Signal-Samples, wobei jedes gefilterte Signal-Sample eine gewichtete Summierung von N aufeinander folgenden Samples des Analogsignals mit N individuellen, in Abhängigkeit von der zu realisierenden Filterfunktion gewählten Gewichtungskoeffizienten repräsentiert, **dadurch gekennzeichnet, dass** es einen Transkonduktanzverstärker (AGM) mit regelbarer Transkonduktanzverstärkung umfasst, der das Analogsignal empfängt und einen Ausgangsstrom liefert, der den Wert dieses Signals multipliziert mit einer Transkonduktanzverstärkung (k) vom Verstärker liefert, wenigstens ein Abtastglied (C_{E}), das über einen Schalter (SW) so mit dem Ausgang des Transkonduktanzverstärkers verbunden ist, dass es N aufeinander folgende Samples mit durch den Ausgangsstrom (di) des Verstärkers bewirkten Ladungen empfängt und die von diesen N aufeinander folgenden Samples erzeugten Ladungen periodisch speichert, und Mittel zum Regeln der Transkonduktanzverstärkung des Verstärkers, um eine individuelle gewünschte Verstärkung am Verstärker für jedes der N Samples zu erhalten, wobei die Folge von N Verstärkungen die gewünschte Filterfunktion definiert.

2. Abtastfilter nach Anspruch 1, **dadurch gekennzeichnet, dass** es wenigstens zwei Abtastglieder (C_{EI}, C'_{EI}) umfasst, die mit dem Ausgang des Verstärkers verbunden sind und abwechselnd die Serien von N aufeinander folgenden Samples bearbeitet, wobei eines der Glieder abtastet, während das andere die gespeicherte Ladung hält und liest.

3. Abtastfilter nach einem der Ansprüche 1 und 2, **dadurch gekennzeichnet, dass** der Transkonduktanzverstärker zwei verschiedene Ausgänge (S1, S2) aufweist, die jeweils auf wenigstens ein selbes Abtastglied (C_{EI}) angewendet werden.

4. Abtastfilter nach einem der Ansprüche 1 bis 3 für eine um 90° phasenverschobene Abtastung, das an seinem/n Ausgang/Ausgängen I-Samples und Q-Samples um 90° zueinander phasenverschoben liefert, **dadurch gekennzeichnet, dass** es ebenso viele Abtastglieder (C_{EI}, C'_{EI}) zum Speichern von N I-Samples wie Abtastglieder (C_{EQ}, C'_{EQ}) zum Speichern von N Q-Samples umfasst.

5. Abtastfilter nach einem der Ansprüche 1 bis 4, **dadurch gekennzeichnet, dass** es ein Netz von Widerständen (R₁, ..Rₘ) umfasst, das durch Logiksignale gesteuert werden kann, um die Verstärkung des Transkonduktanzverstärkers zu justieren.

6. Abtastfilter nach einem der Ansprüche 1 bis 5, **dadurch gekennzeichnet, dass** es einen MOS-Transistor (MN5) zum Bilden eines durch eine Gitterspannung gesteuerten Regelwiderstands und einen Digital-Analog-Wandler (DAC) zum Empfangen von Verstärkungsregelungslogiksignalen und zum Umwandeln derselben in eine Gitterspannung des Transistors umfasst.

7. Abtastfilter nach einem der Ansprüche 5 und 6, **dadurch gekennzeichnet, dass** sich das Mittel zum Regeln der Verstärkung am Spannungseingang des Transkonduktanzverstärkers befindet, um ein Spannungssignal zu empfangen und diese Spannung in einem regelbaren Verhältnis vor dem Umwandeln der gedämpften Spannung in Strom zu dämpfen.

8. Abtastfilter nach einem der Ansprüche 5 und 6, **dadurch gekennzeichnet, dass** der Transkonduktanzverstärker ein Widerstandselement (R) zum Transformieren von Spannungsvariationen (dv) in Stromvariationen (di) mit einer Verstärkung umfasst, die durch den Wert des Widerstands bestimmt wird, und dadurch, dass das Widerstandselement ein Satz von durch Logiksignale wählbaren Widerständen ist, um einen Widerstand mit einem gewählten Wert unter mehreren möglichen Werten zu bilden.

9. Abtastfilter nach einem der Ansprüche 5 und 6, **dadurch gekennzeichnet, dass** der Transkonduktanzverstärker ein Widerstandselement (R) zum Transformieren von Spannungsvariationen (dv) in Stromvariationen (di) mit einer Verstärkung umfasst, die durch den Wert des Widerstands bestimmt wird, und dadurch, dass dieses Widerstandselement ein MOS-Transistor ist, der durch eine variable Gitterspannung gesteuert wird.
